Europäisches Patentamt

European Patent Office

Office européen des brevets

(11) Publication number: **0 382 397**
**A1**

# EUROPEAN PATENT APPLICATION

(21) Application number: **90300995.9**

(22) Date of filing: **31.01.90**

(51) Int. Cl.5: **H01L 23/473, H01L 23/433**

(30) Priority: **06.02.89 JP 25726/89**

(43) Date of publication of application:
**16.08.90 Bulletin 90/33**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Kikuchi, Shunichi**
**25-8 Hiyoshi 2-chome, Kohoku-ku**
**Yokohama-shi, Kanagawa 223(JP)**

(74) Representative: **Rackham, Stephen Neil et al**
**GILL JENNINGS & EVERY 53-64 Chancery**
**Lane**
**London WC2A 1HN(GB)**

(54) **Cooling head for integrated circuit.**

(57) A cooling head (5) projects from an underside of a cooling plate (11), and has a heat-conductive plate (17) fixed on its free end for thermal contact with an integrated circuit element. A nozzle (19) directs a jet (S) of cooling medium towards the heat-conductive plate (17) to cool the integrated circuit element by a heat exchange through the heat-conductive plate (17). An inwardly extending baffle (20a) is provided in the cooling head (5) above the heat-conductive plate (17) and covering a peripheral area of the heat-conductive plate (17) so that a rising current of the cooling medium derived from the jet (S) fed from the nozzle (19) and impinging on the heat-conductive plate (17) is converted to vortices (W) circulating between a central and peripheral area of the heat-conductive plate (17). With this structure, the cooling efficiency of the cooling head is improved and is more uniform over the entire surface of the heat-conductive plate (17).

Fig. 1

## COOLING HEAD FOR INTEGRATED CIRCUIT

The present invention relates to a cooling head secured on a cooling plate for cooling an integrated circuit element mounted on a printed circuit board.

Since modern integrated circuit elements are highly densified and operate at a high speed, the heat generated during operation is greater than that generated by conventional elements. Accordingly, various proposals have been made with regard to quenching the heat generated from the integrated circuit element, to thereby ensure a stable operation thereof. These include forced cooling systems in which the integrated circuit elements are cooled by indirect contact with a cooling medium, usually water.

In one such conventional system a cooling head projecting from an underside of a cooling plate for cooling an integrated circuit element comprises, a heat-conductive plate for thermal contact with the integrated circuit element fixed on a free end of the cooling head and a nozzle in the inside of the cooling head to direct a jet of cooling medium towards the heat-conductive plate to cool an integrated circuit element by a heat exchange through the heat-conductive plate. As will be described in detail subsequently such cooling heads do not provide a uniform cooling efficiency over the surface of their heat-conductive plates.

According to this invention such a cooling head includes an inwardly extending baffle in the cooling head above the heat-conductive plate and covering a peripheral area of it so that a rising current of the cooling medium derived from the jet fed from the nozzle and impinging on the heat-conductive plate is converted in a vortex circulating between the central and peripheral area of the heat-conductive plate.

With the present invention, the primary jet of the cooling medium fed from the nozzle is spread along the surface of the heat-conductive plate after impingement thereon, and this flow is then deflected upward by the inner wall of the cooling head as a rising current. The rising current is pushed down to form vortices in this space, and these vortices accelerate the newly fed cooling medium flowing along the heat-conductive plate, so that a temperature boundary layer adhered to the surface of the heat-conductive plate is activated and renewed. This enhances the high heat transmission through the heat-conductive plate and results in a uniform cooling effect throughout the total area of the heat-conductive plate.

Various embodiments of the present invention will now be described and contrasted with the prior art with reference to the accompanying drawings, wherein;

Fig. 1 is a side sectional view of a first embodiment of a cooling head according to the present invention;

Figs. 2(a) and 2(b), respectively are a diagram of a velocity vector illustrating a flow of a cooling medium in a cooling head according to the present invention;

Fig 2(c) is a diagram similar to Figs. 2(a) and 2(b) but showing a convention cooling head;

Fig. 3 is a side sectional view of a third embodiment of the present invention;

Fig. 4 is a side sectional view of a third embodiment of the present invention;

Fig. 5 is a general perspective view of a cooling plate;

Fig. 6 is a side sectional view of a conventional cooling head; and,

Fig. 7 is a graph showing one example of a transition of a heat transmission state using a nusselt number in accordance with a radial position on a heat-conductive plate, where $\ell/d$ is set at a constant value of 1.3.

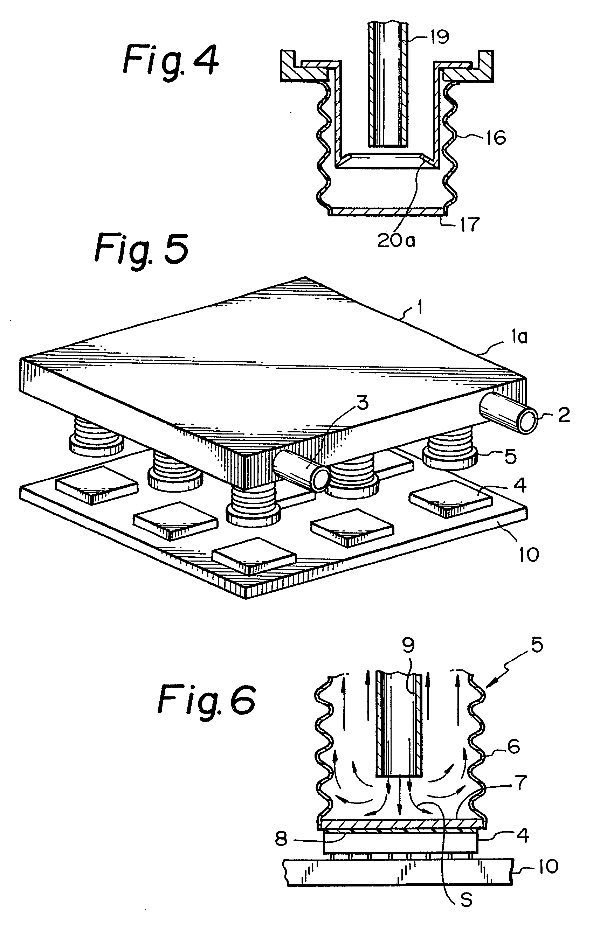

The general arrangement of a cooling system incorporating a cooling head in accordance with this invention is shown in Figure 5, in which a cooling plate 1 is disposed above a printed circuit board constituting an electronics circuit package. The cooling plate 1 comprises a plate body 1a with an inlet port 2 for introducing a cooling water into the interior of the plate 1a, and an exit port 3 for discharging the cooling water therefrom. A plurality of cooling heads 5 are projected from the underside of the cooling plate 1 so that a free end of each cooling head 5 is in contact with a top surface of an integrated circuit element 4 mounted on a printed circuit board 10.

A conventional structure of the cooling head 5 will be explained with reference to Fig. 6. The cooling head 5 comprises a bellows 6 made of a metal such as stainless steel or copper alloy, and a heat-conductive plate 7 fixed to a free end of the bellows 6. The heat-conductive plate 7 is in contact, via a thermal compound 8, with a heat-sink area of the integrated circuit element 4 provided on the top surface thereof, at a predetermined pressure. A nozzle 9 is disposed in the interior of the cooling head 5 and directed toward the center of the heat-conductive plate 7, and a cooling medium (water) is fed therethrough by a pump, not shown, as a jet S and impinged onto the heat-conductive plate 7. After quenching the integrated circuit element 4 through the heat-conductive plate 7, the now warm cooling medium, due to a heat exchange, is conveyed by a rising current around the nozzle 9 and discharged from the exit port 3. The cooling medium is then cooled outside the cooling plate 1 and returned to the interior of the cooling plate 1 by the pump.

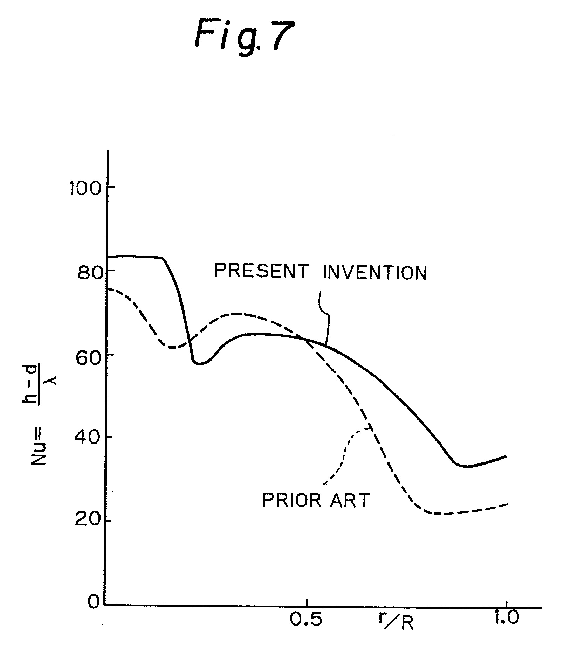

According to this conventional cooling system, since the heat transmission between the heat-conductive plate 7 and the cooling medium mainly relies upon the impingement of the jet S on the heat-conductive plate 7, the cooling efficiency is not high, although still superior to a forcible convection current system. Particularly, as apparent from a graph of a nusselt number shown by a dotted line in Fig. 7, the heat-transmission efficiency becomes lower as the distance from a center of the nozzle 9 is increased; i.e., the heat transmission efficiency is much lower at the peripheral area of the heat-conductive plate than of the central area thereof, even in one cooling head. This is assumed to be because a temperature boundary layer formed on the surface of the heat-conductive plate is not sequentially renewed in the peripheral area of the heat-conductive plate, due to a lower velocity of the cooling medium and smaller generation of vortices. In this connection, the "nusselt number Nu" is a non-dimensional number representing a heat transmission state, and is defined by the following equation:

$$Nu = h \cdot d / \lambda$$

wherein h is a heat transmission coefficient between a cooling medium and a heat-conductive plate; d is an inner diameter of a nozzle; and $\lambda$ is a heat conductivity coefficient of a cooling medium.

In the graph shown in Fig. 7, since both d and $\lambda$ are constant, Nu is substantially proportional to the heat transmission coefficient.

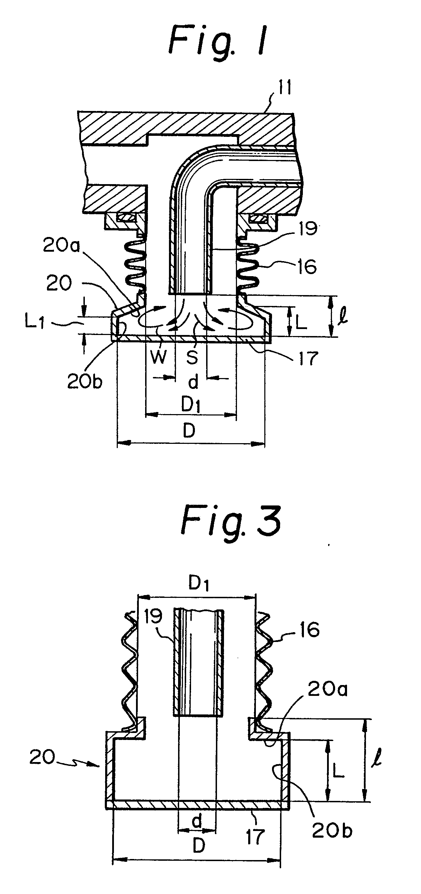

Figure 1 is a side sectional view of a first embodiment of a cooling head according to the present invention. An explanation of parts similar to those of the conventional unit already described with reference to Fig. 6 is omitted, and only the distinction therebetween will be explained below. In this regard , ten is added to the reference numerals of Fig. 6, to represent the same or similar parts in Fig. 1.

As shown in Fig. 1, a cooling head 15 according to the present invention is also provided with a bellows 16 and a heat-conductive plate 17, and adapted to quench an integrated circuit element (not shown) in contact with the heat-conductive plate 17 by a cooling medium fed through a nozzle 19 disposed in the interior of the cooling head 15.

In this embodiemnt, the heat-conductive plate 17 is closely fixed to a bottom of a housing 20 in a truncated conical shape having a downwardly diverging inner diameter. The housing 20 is disposed in an area lower than a discharging end of the nozzle 19, and as a result, the interior of the cooling head 15 is divided into an upper portion in which the nozzle 19 is disposed and a lower portion in which the heat-conductive plate 17 is fixed.

An inner diameter of the upper portion is defined by an inner diameter $D_1$ of the bellows 16, and an inner diameter of the lower portion is defined by a diameter D of the heat-conductive plate 17. The bellows 16 and the heat-conductive plate 17 are connected by a slanted side wall 20a of the housing 20.

The cooling medium fed downward from the nozzle 19 first impinges on the center of the heat-conductive plate 17, flows toward the periphery of the heat-cnductive plate 17 along the surface thereof, and is then deviated upward by the side wall of housing 20. During this deviation, the flow of the cooling medium is inwardly directed by the side wall 20a slanted inward and upward and forming a baffle, whereby annular vortices 40 are formed between the periphery and the center of the heat-conductive plate 17.

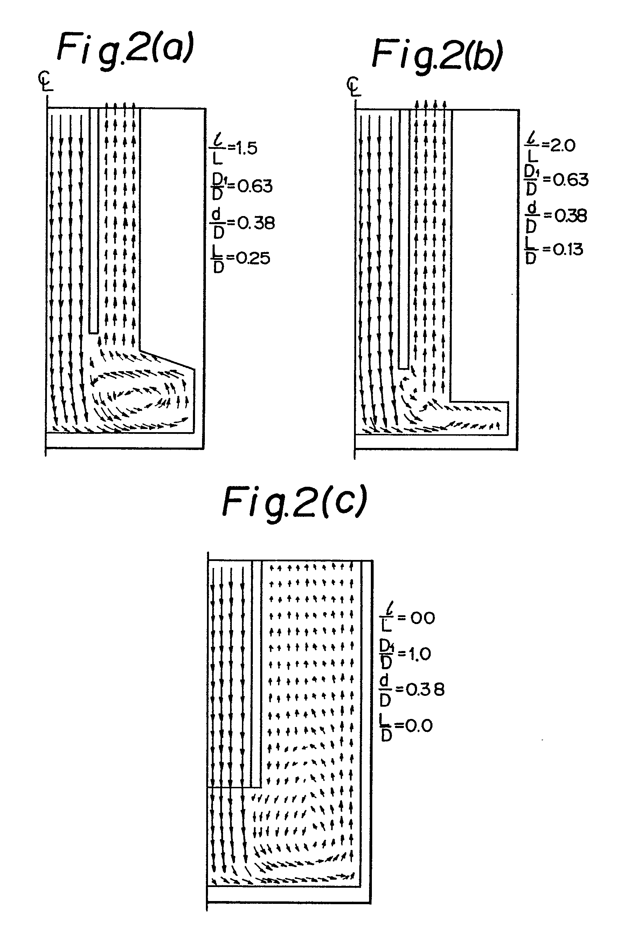

Figures 2 (a), (b) and (c) illustrate, respectively, a flow of the cooling medium (water) in the interior of the cooling head, in which a flow velocity is represented as a vector at the respective position within the interior of the cooling head. In this connection, Fig. 2 (a) shows a case in which a cooling head according to the present invention shown in Fig. 1 is used; Fig. 2 (b) shows a case in which another cooling head according to the present invention shown in Fig. 3 is used; and Fig. 2 (c) shows a case in which the conventional cooling head shown in Fig. 6 is used. The dimensional relationships between the respective parts are defined as follows:

In the case of (a)

$l/L = 1.5$, $d/D = 0.38$, $D_1/D = 0.63$, $L/D = 0.25$, $L_1/L = 0.33$;

in the case of (b)

$l/L = 2.0$, $d/D = 0.38$, $D_1/d = 0.63$, $L/D = 0.13$, $L_1/L = 0$; and

in the case of (c)

$l/L = \infty$, $d/D = 0.38$, $D_1/D = 1.0$, $L/D = 0$, $L_1/L = 0$;

wherein the respective references represent dimensions of portions corresponding to those defined in Fig. 1; i.e.,

L is a distance between the upper end of the baffle 20a and the heat-conductive plate 17;

$L_1$ is a height of a vertical side wall 20b of the housing 20;

$l$ is a distance between the heat-conductive plate 17 and the lower end of the nozzle 19;

D is a diameter of the heat-conductive plate 17;

$D_1$ is a minimum inner diameter of the housing 20; and

d is an inner diameter of the nozzle 19.

All other cooling conditions are identical for each case.

In these diagrams, as an arrow representing a velocity of the cooling medium becomes larger, a flow rate thereof becomes faster, and coversely, as the arrow becomes smaller and narrows to a point, the cooling medium flow is stopped.

It is clearly shown in Fig. 2 (a) that, after impinging onto the heat conductive plate 17, the cooling medium flows on the surface of the heat-conductive plate 17 from the center to the periphery thereof, while forming a laminar flow, then is returned as annular vortices to the center by the action of the baffle 20a. The diagram further shows that a high cooling efficiency is assured because the velocity of the cooling medium flowing along the surface of the heat-conductive plate 17 is high.

In fact, as shown in Fig. 7 by a solid line, Nusselt numbers in the cooling head accordng to the present invention, determined as a function of a radial distance from the center of the heat-conductive plate 17, have a higher value throughout substantially the whole area than those of the conventional cooling head shown by a dotted line and described above.

I the case of Fig. 2 (b), the generation of vortices similar to those of Fig. 2 (a) is recognizable, but it is considered that the cooling efficiency is lower than in the former case because the velocity vectors in the peripheral area of the heat-conductive plate are smaller than in the former case.

On the other hand, in the case of Fig. 2 (c), no annular vortices above the heat-conductive plate are observed, but instead, after the impingement onto the heat-conductive plate, the cooling medium fed from the nozzle flows upward along a vertical side wall of the cooling head as a rising current, and as a result, the cooling medium flowing along the surface of the heat-conductive plate cannot be accelerated, and thus the velocity thereof becomes smaller as it extends from the center to the periphery of the heat-conductive plate, which leads to an inferior cooling efficiency in the peripheral area thereof.

It should be noted that the present invention is not limited to the above-described desirable data, since such the data is derived from experiments under particular conditions for the feeding of the cooling medium, and by the use of particular dimensioned cooling heads.

In Figs. 1 and 3, the cooling head according to the present invention has a baffle for generating vortices integral with a head housing. Another structure of a baffle is possible, as shown in Fig. 4, in which a separately prepared baffle 30 is fixed in the interior of the cooling head.

## Claims

1. A cooling head (5) projecting from an underside of a cooling plate (11) for cooling an integrated circuit element comprises, a heat-conductive plate (17) for thermal contact with the integrated circuit element fixed on a free end of the cooling head (5) and a nozzle (19) in the inside of the cooling head (5) to direct a jet (S) of cooling medium towards the heat-conductive plate (17) to cool an integrated circuit element by a heat exchange through the heat-conductive plate (17); characterized in that the cooling head (5) includes an inwardly extending baffle (20a) in the cooling head (5) above the heat-conductive plate (17) and covering a peripheral area of it so that a rising current of the cooling medium derived from the jet (S) fed from the nozzle (19) and impinging on the heat-conductive plate (17) is converted in a vortex circulating between the central and peripheral area of the heat-conductive plate (17).

2. A cooling head according to claim 1, in which the baffle (20a) is formed integrally with the side wall (20) of part of the cooling head (5).

3. A cooling head according to claim 1, in which the baffle (20a, Figure 4) is formed separately from the side wall of the cooling head (5) and is inserted within the interior of the cooling head (5).

4. A cooling head according to anyone of the preceding claims, in which the baffle (20a) has a frusto-conical shape and diverges downwardly.

## Fig. 1

## Fig. 3

# Fig.2(a)

$\frac{\ell}{L}=1.5$

$\frac{D_1}{D}=0.63$

$\frac{d}{D}=0.38$

$\frac{L}{D}=0.25$

# Fig.2(b)

$\frac{\ell}{L}=2.0$

$\frac{D_1}{D}=0.63$

$\frac{d}{D}=0.38$

$\frac{L}{D}=0.13$

# Fig.2(c)

$\frac{\ell}{L}=0.0$

$\frac{D_1}{D}=1.0$

$\frac{d}{D}=0.38$

$\frac{L}{D}=0.0$

*Fig.4*

*Fig.5*

*Fig.6*

# Fig.7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 196 054 (HITACHI LTD) <br> * Abstract; figure 12 * | 1,2 | H 01 L 23/473 <br> H 01 L 23/433 |
| Y |  | 4 |  |
|  | --- |  |  |
| X | PATENT ABSTRACTS OF JAPAN, vol. 11, no. 130 (E-502), 23rd April 1987; & JP-A-61 276 242 (HITACHI LTD) 06-12-1986 <br> * Abstract * | 1,2 |  |
|  | --- |  |  |
| Y | EP-A-0 217 676 (FUJITSU LTD) <br> * Figure 31 * | 4 |  |
|  | --- |  |  |
| A | US-A-4 750 086 (UNISYS CORP.) <br> * Figure 2 * | 1 |  |
|  | ----- |  |  |

TECHNICAL FIELDS SEARCHED (Int. Cl.5)

H 01 L 23/00

The present search report has been drawn up for all claims

| Place of search | Date of completion of the search | Examiner |
|---|---|---|
| THE HAGUE | 27-04-1990 | ZEISLER P.W. |

EPO FORM 1503 03.82 (P0401)